# EUROPÄISCHE PATENTSCHRIFT

(11) **EP 3 325 874 B1**
(45) Veröffentlichungstag und Bekanntmachung des Hinweises auf die Patenterteilung: **25.09.2019**
(21) Anmeldenummer: 16729815.7
(22) Anmeldetag: 02.06.2016
(51) Int. Cl.: F21K 9/64, F21V 9/30, F21V 25/02, G01N 27/20

(54) **WELLENLÄNGENUMWANDLUNG VON PRIMÄRLICHT MITTELS EINES KONVERSIONSKÖRPERS**
WAVELENGTH CONVERSION OF PRIMARY LIGHT BY MEANS OF A CONVERSION BODY
CONVERSION DE LONGUEUR D'ONDE DE LUMIÈRE PRIMAIRE AU MOYEN D'UN CORPS DE CONVERSION

(30) Priorität: 17.07.2015 DE 102015213460
(43) Veröffentlichungstag der Anmeldung: 30.05.2018
(73) Patentinhaber: OSRAM GmbH, 80807 München (DE)
(72) Erfinder: VOGT, Peter, 93309 Kelheim (DE); NAUEN, Andre, 93051 Regensburg (DE)
(86) Internationale Anmeldenummer: PCT/EP2016/062481
(87) Internationale Veröffentlichungsnummer: WO 2017/012763

(56) Entgegenhaltungen:
- DE-A1- 4 125 478
- DE-A1-102011 017 633
- FR-A1- 2 580 403
- JP-A- 2010 118 267
- US-A1- 2010 072 486
- US-A1- 2014 009 952

## Beschreibung

Die Erfindung betrifft einen Konversionskörper, aufweisend einen Grundkörper aus wellenlängenumwandelndem Leuchtstoff, der eine zur Bestrahlung mit Primärlicht vorgesehene Bestrahlungsfläche aufweist. Die Erfindung betrifft auch eine Konversionseinrichtung, aufweisend mindestens einen Konversionskörper und eine Auswerteeinrichtung, wobei die Auswerteeinrichtung dazu eingerichtet ist, einen Riss in dem Grundkörper festzustellen. Die Erfindung betrifft ferner eine Beleuchtungsvorrichtung, aufweisend mindestens eine Konversionseinrichtung und mindestens eine Halbleiter-Primärlichtquelle zum Bestrahlen der Bestrahlungsfläche des zugehörigen Grundkörpers. Die Erfindung ist beispielsweise anwendbar auf wellenlängenumwandelnde Keramikkörper als Grundkörper. Die Erfindung ist beispielsweise anwendbar auf LARP-Anordnungen, insbesondere auf Beleuchtungsvorrichtungen für Fahrzeuge (z.B. Scheinwerfer) oder für Spezialbeleuchtungen wie Bühnen- oder Effektbeleuchtungen.

Es ist bekannt, Primärlicht einer vorgegebenen Primärlicht-Wellenlänge (z.B. blaues Licht) auf einen wellenlängenumwandelnden Keramikkörper zu strahlen, wo das Primärlicht zumindest teilweise in Licht größerer Wellenlänge (z.B. in gelbes Licht) umgewandelt und wieder abgestrahlt wird. Der Keramikkörper kann aus seltenerd-dotierter Keramik mit Granatstruktur bestehen (wie beispielsweise in DE 10 2007 010 719 A1 offenbart) und ist typischerweise plättchenförmig. Er wird typischerweise mittig mit dem Primärlicht bestrahlt. Ist das Primärlicht Laserlicht und ist der Keramikkörper von dem das Primärlicht erzeugenden Laser beabstandet, wird auch von einer LARP("Laser Activated Remote Phosphor")-Anordnung gesprochen.

Bei der Bestrahlung des Keramikkörpers kommt es an der Bestrahlungsfläche zu einer deutlichen lokalen Temperaturerhöhung, die zu einer Erzeugung thermisch induzierter Spannungen in dem Keramikkörper und ggf. zu einer Schädigung des wellenlängenumwandelnden Keramikkörpers durch Rissbildung führen kann. Die Gefahr einer Rissbildung kann sich durch wiederholtes Ein- und Ausschalten des Primärlichts über die Zeit erhöhen, da eine damit zusammenhängende thermisch induzierte Wechsellast zu einem langsamen Risswachstum führen kann.

Risse in dem wellenlängenumwandelnden Keramikkörper können bisher durch aufwändige optische Analyse des von dem Keramikkörper ausgehenden Lichts erkannt werden.

Die US 2010/072486 A1 offenbart eine Beleuchtungsvorrichtung mit einer Konversionseinrichtung und einem Konversionskörper zur Wellenlängenkonversion von Licht, wobei der Konversionskörper ebene Flächen zur Lichteinkopplung und Lichtauskopplung sowie seitliche Oberflächen, die lichtreflektierend ausgebildet sind, aufweist.

Die DE 10 2011 017633 A1 offenbart eine Leuchtstoffanordnung mit einem Leuchtstoff, der auf einer Oberfläche eines Substrats angeordnet ist, und eine metallische Schicht, die auf dem Leuchtstoff angeordnet ist.

Die US 2014/009952 A1 offenbart eine Beleuchtungsvorrichtung mit einer Laserlichtquelle und einem Konversionskörper zur Wellenlängenkonversion von Licht sowie einer Leitungsführung, die über den Konversionskörper geführt ist, um im Fall eines Defekts die Laserlichtquelle abzuschalten.

Die JP 2010 118267 A offenbart eine Beleuchtungsvorrichtung mit einer Lichtquelle und einer Betriebsschaltung für die Lichtquelle sowie einer Abdeckung, wobei eine elektrische Verbindung zwischen der Lichtquelle und der Betriebsschaltung über die Abdeckung geführt ist.

Die DE 41 25 478 A1 offenbart einen Scheinwerfer mit einem Reflektor und einer darin angeordneten Lampe, wobei am Reflektor ein UV-Lichtfilter mit einer auf dem Filter aufgebrachten Leiterbahn angeordnet ist, um den Lampenbetrieb bei defektem UV-Lichtfilter und unterbrochener Leiterbahn zu verhindern.

Die FR 2 580 403 A1 offenbart ein Verfahren zur Bestimmung von Rissparametern.

Es ist die **Aufgabe** der vorliegenden Erfindung, die Nachteile des Standes der Technik zumindest teilweise zu überwinden und insbesondere eine einfache und preiswerte Möglichkeit bereitzustellen, eine Schädigung eines Leuchtstoffkörpers durch Rissbildung erkennen zu können.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch einen Konversionskörper, welcher einen Grundkörper aus wellenlängenumwandelndem Leuchtstoff, der mindestens eine zur Bestrahlung mit Primärlicht vorgesehene Bestrahlungsfläche aufweist, und mindestens eine auf dem Grundkörper außerhalb der Bestrahlungsfläche angebrachte elektrisch leitfähige Leitungsspur aufweist.

Dieser Konversionskörper ergibt den Vorteil, dass sich ein Riss durch den Grundkörper auch durch eine elektrische Leitungsspur ausbreitet, die mit dem Grundkörper fest verbunden ist, da die sich in dem Grundkörper bildenden Rissflanken auch die daran angrenzende elektrische Leitungsspur aufziehen oder aufreißen und dadurch beschädigen. Die Schädigung der Leitungsspur kann mit einer elektrischen Auswerteeinrichtung einfach und preiswert sowie besonders genau festgestellt werden. Aus der Schädigung der Leitungsspur kann folglich auf eine Schädigung des Grundkörpers zurückgeschlossen werden.

Dabei wird ausgenutzt, dass bei der Bestrahlung des Grundkörpers dieser an der Bestrahlungsfläche eine thermisch induzierte, radial gerichtete Kompression erfährt, durch die der Keramikkörper insbesondere auch außerhalb der Bestrahlungsfläche radial nach außen gedrückt wird. Dadurch wiederum werden Spannungen in Umfangsrichtung um die Bestrahlungsfläche herum erzeugt, welche eine Rissbildung bewirken können. Da die Ausbreitungsrichtung der Risse durch die Form des Grundkörpers und die Spannungsverteilung in dem Grundkörper gut vorhersagbar ist, ist auch ein Rissverlauf gut vorhersagbar. Durch eine geeignete Verlegung der mindestens einen Leitungsspur ist eine Rissbildung dann auch mit hoher Wahrscheinlichkeit durch eine zugehörige Schädigung mindestens einer Leitungsspur erkennbar.

Unter einem Konversionskörper wird insbesondere ein einstückiger (d.h., nicht ohne Zerstörung teilbarer) Körper verstanden, der den Grundkörper und damit fest verbunden die mindestens eine elektrisch leitfähige Leitungsspur aufweist.

Unter einer Leitungsspur wird insbesondere eine praktisch eindimensional ausgedehnte elektrische Leitung verstanden, d.h., dass eine Längserstreckung der Leitung erheblich (insbesondere um mindestens einen Faktor 2, insbesondere um mindestens eine Größenordnung) größer ist als eine Breite und eine Höhe. Die Leitungsspur kann z.B. ein in den Grundkörper eingearbeiteter Draht oder eine oberflächlich auf dem Grundkörper angebrachte Leiterbahn sein.

Jedoch kann die Leitungsspur grundsätzlich eine beliebige Form aufweisen und allgemein auch als eine Leitungsfläche bezeichnet werden. Dies gilt insbesondere, falls ein Ort einer zukünftig möglicherweise auftretenden Rissbildung gut bekannt ist.

Es ist eine Weiterbildung, dass der Grundkörper ein spröder Körper ist. Dieser reißt nahe seiner Elastizitätsgrenze ohne oder mit nur geringer plastischer Verformung, d.h., durch Sprödbruch.

Der Grundkörper weist Leuchtstoff auf oder besteht aus Leuchtstoff und kann daher einfallendes Primärlicht zumindest teilweise in Sekundärlicht unterschiedlicher Wellenlänge umwandeln oder konvertieren. Bei Vorliegen mehrerer Leuchtstoffe können diese Sekundärlicht von zueinander unterschiedlicher Wellenlänge erzeugen. Die Wellenlänge des Sekundärlichts mag länger sein (sog. "Down Conversion") oder kürzer sein (sog. "Up Conversion") als die Wellenlänge des Primärlichts. Beispielsweise kann blaues Primärlicht mittels eines Leuchtstoffs in grünes, gelbes, orangefarbenes oder rotes Sekundärlicht umgewandelt werden. Bei einer nur teilweisen Wellenlängenumwandlung oder Wellenlängenkonversion wird von dem Grundkörper eine Mischung aus Sekundärlicht und nicht umgewandelten Primärlicht abgestrahlt, die als Nutzlicht dienen kann. Beispielsweise mag weißes Nutzlicht aus einer Mischung aus blauem, nicht umgewandeltem Primärlicht und gelbem Sekundärlicht erzeugt werden. Jedoch ist auch eine Vollkonversion möglich, bei der das Nutzlicht entweder nicht mehr oder zu einem nur vernachlässigbaren Anteil in dem Nutzlicht vorhanden ist. Ein Umwandlungsgrad hängt beispielsweise von einer Dicke und/oder einer Leuchtstoffkonzentration des Grundkörpers ab. Bei Vorliegen mehrerer Leuchtstoffe können aus dem Primärlicht Sekundärlichtanteile unterschiedlicher spektraler Zusammensetzung erzeugt werden, z.B. gelbes und rotes Sekundärlicht. Das rote Sekundärlicht mag beispielsweise dazu verwendet werden, dem Nutzlicht einen wärmeren Farbton zu geben, z.B. sog. "warm-weiß". Bei Vorliegen mehrerer Leuchtstoffe mag mindestens ein Leuchtstoff dazu geeignet sein, Sekundärlicht nochmals wellenlängenumzuwandeln, z.B. grünes Sekundärlicht in rotes Sekundärlicht. Ein solches aus einem Sekundärlicht nochmals wellenlängenumgewandeltes Licht mag auch als "Tertiärlicht" bezeichnet werden.

Es ist eine Ausgestaltung, dass der Grundkörper ein Leuchtstoffplättchen ist, dessen Bestrahlungsfläche sich auf einer Flachseite befindet. Die Bestrahlungsfläche kann sich insbesondere mittig auf der Flachseite befinden. Unter einer mittigen Anordnung wird insbesondere eine Anordnung verstanden, bei der die Bestrahlungsfläche nicht bis zu dem Rand des Leuchtstoffplättchens reicht, sondern davon allseitig beabstandet ist.

Es ist noch eine Ausgestaltung, dass zumindest eine Leitungsspur (im Folgenden ohne Beschränkung der Allgemeinheit als "randseitige Leitungsspur" bezeichnet) entlang zumindest eines Teils oder Abschnitts eines (freien) Rands der Flachseite, welche die Bestrahlungsfläche aufweist, verläuft. Dies ergibt den Vorteil, dass eine Rissbildung in dem Grundkörper besonders früh erkannt werden kann. Dabei wird die Erkenntnis ausgenutzt, dass durch die mittige radiale Kompression des Grundkörpers bei Erwärmung der Bestrahlungsfläche an dem freien Rand Zugspannungen in Umfangsrichtung erzeugt werden, welche dort ggf. vorhandene Vorschädigungen leichter zu Rissen öffnen oder weiterentwickeln können als im Inneren des Grundkörpers. Zudem treten an dem Rand Rissinitiierungsstellen (wie Kerben, Anrisse usw.) meist häufiger auf als in dem Grundkörper. Folglich entstehen Risse häufig zuerst am Rand des Grundkörpers.

Die Anordnung "entlang" des Rands kann umfassen, dass die Leitungsspur unmittelbar an den Rand angrenzt und ggf. sogar die an den Rand anschließende Randseite oder Schmalseite bedeckt. Ist die Leitungsspur ein Draht, kann unter einer unmittelbar an den Rand angrenzenden Anordnung eine Anordnung des Drahts verstanden werden, die den Draht herstellungstechnisch soweit wie praktisch möglich dem Rand nahebringt.

Die Anordnung "entlang" des Rands kann auch umfassen, dass die Leitungsspur mit einem nur geringen Abstand von dem Rand entfernt ist. Der geringe Abstand kann z.B. nicht mehr als 200 Mikrometer, insbesondere nicht mehr als 100 Mikrometer, insbesondere nicht mehr als 75 Mikrometer, insbesondere nicht mehr als 50 Mikrometer, insbesondere nicht mehr als 25 Mikrometer, betragen.

Es ist eine Weiterbildung davon, dass mehrere randseitige Leitungsspuren entlang jeweiliger Teile oder Abschnitte des Rands der Flachseite verlaufen.

Es ist eine weitere Ausgestaltung, dass die randseitige Leitungsspur praktisch (d.h., bis auf eine vorgegebene (schmale) Unterbrechung in der Leitungsspur) entlang des ganzen Rands der die Bestrahlungsfläche aufweisenden Flachseite verläuft. Dies ergibt den Vorteil, dass randseitig initiierte Risse mit einer besonders hohen Wahrscheinlichkeit erkannt werden können. Die Unterbrechung (z.B. ein schmaler Spalt) dient zur Verhinderung eines Kurzschlusses in der Leitungsspur.

Es ist noch eine weitere Ausgestaltung, dass die randseitige Leitungsspur entlang mindestens einer randseitig (gezielt) eingebrachten mechanischen Vorschädigung verläuft. Dadurch kann ein Ort einer möglichen ersten Rissbildung gezielt voreingestellt werden, was eine besonders sichere Erkennung einer thermischen Überbeanspruchung ermöglicht. Auch kann so eine Auslöseschwelle der Zugspannung zur Rissauslösung zumindest annähernd eingestellt werden. Als weiterer Vorteil ergibt sich, dass besonders wenig Material der Leitungsspur benötig wird und zudem eine Form der Leitungsspur besonders frei wählbar ist (z.B. im Sinne einer Leitungsfläche). Die Vorschädigung kann eine Einkerbung sein.

Es ist ferner eine Ausgestaltung, dass mindestens eine weitere Leitungsspur zwischen der randseitigen Leitungsspur und der Bestrahlungsfläche verläuft. Dadurch kann ein Fortschritt einer Rissausbreitung besonders sicher erfasst werden. Beispielsweise kann ein noch kurzer Riss durch eine Änderung der elektrischen Eigenschaft der randseitigen Leitungsspur erfasst werden und eine weitere Rissausbreitung in Richtung der Bestrahlungsfläche durch eine Änderung der elektrischen Eigenschaft der mindestens einen weiteren Leitungsspur erfasst werden.

Es ist außerdem eine Ausgestaltung, dass mindestens eine weitere Leitungsspur beabstandet formähnlich zu der randseitigen Leitungsspur verläuft. Dadurch lässt sich ein Rissfortschritt mit einer vorbestimmten Risslänge zumindest ungefähr von praktisch allen Randpositionen aus erkennen.

Es ist auch eine Ausgestaltung, dass der Grundkörper aus wellenlängenumwandelnder Keramik besteht, z.B. aus seltenerd-dotierter Keramik mit Granatstruktur.

Es ist eine alternative Weiterbildung, dass der Grundkörper aus einem spröden Matrixmaterial besteht, in dem pulverförmige Leuchtstoffpartikel eingebettet sind. Das spröde Matrixmaterial kann beispielsweise Glas sein.

Es ist zudem eine Ausgestaltung, dass mindestens eine elektrisch leitfähige Leitungsspur eine Leiterbahn, insbesondere eine metallische Leiterbahn, ist. Eine Leiterbahn lässt sich auf preiswerte Weise besonders einfach, präzise und fein strukturiert auf eine Oberfläche des Grundkörpers aufbringen.

Es ist eine Weiterbildung, dass mindestens eine metallische Leiterbahn aus Aluminium besteht. Aluminium weist den Vorteil auf, dass es vergleichsweise weich und duktil ist und daher bei einer Rissausbreitung in dem Grundkörper unterhalb der Leitungsspur einfach mit aufreißt. So kann insbesondere verhindert werden, dass ein Riss unter der Leitungsspur hindurchläuft, ohne diese zu schädigen. Das Aluminium kann z.B. aufgesputtertes Aluminium sein. Eine Dicke des Aluminiums kann beispielsweise 100 nm bis 300 nm betragen, insbesondere ca. 200 nm.

Es ist auch noch eine Ausgestaltung, dass die elektrisch leitfähige Leitungsspur ein in den Grundkörper eingebetteter Draht, insbesondere Wolfram aufweisend (d.h. aus reinem Wolfram oder einer Wolfram-Legierung bestehend), ist. Dies ergibt den Vorteil, dass die Leitungsspur besonders temperaturunempfindlich ist und zudem auch robust gegenüber einer ungewollten Bestrahlung mit dem Primärlicht ist. In einer Weiterbildung kann der Draht allseitig in dem Grundkörper eingebettet sein.

Da Wolfram und Wolfram-Legierungen hochgradig temperaturbeständig sind, können sie durch Einlegen in einen den Grundkörper bildenden Grünkörper und Mitsintern mit dem Grünkörper fest in dem Grundkörper eingearbeitet sein.

Es ist zudem noch eine Ausgestaltung, dass die elektrisch leitfähige Leitungsspur (insbesondere Leiterbahn) eine Breite zwischen 100 Mikrometern und 750 Mikrometern aufweist, insbesondere zwischen 100 Mikrometern und 500 Mikrometern, insbesondere zwischen 100 Mikrometern und 300 Mikrometern, insbesondere zwischen 150 Mikrometern und 250 Mikrometern, insbesondere von ca. 200 Mikrometern, aufweist. Dies hat sich als ein besonders vorteilhaftes Maß zur sicheren Feststellung einer Änderung einer elektrischen Eigenschaft der Leitungsspur und einer ausreichend frühzeitigen Risserkennung herausgestellt.

Es ist eine Weiterbildung, dass die mindestens eine Leitungsspur einseitig auf dem Grundkörper aufgebracht ist, was eine besonders einfache Herstellung ermöglicht. Diese Seite kann diejenige Flachseite sein, an der sich die Bestrahlungsfläche befindet. Sie kann alternativ diejenige Flachseite sein, die der Bestrahlungsfläche abgewandt ist.

Es ist eine alternative Weiterbildung, dass auf beiden Flachseiten des Grundkörpers jeweils mindestens eine Leitungsspur aufgebracht ist, insbesondere jeweils gleichgeformte Leitungsspuren.

Es ist noch eine Weiterbildung, dass der Grundkörper in Draufsicht auf seine Flachseite eine kreisrunde oder eine rechteckige Form aufweist, was auch der Form des Rands entspricht. Jedoch ist die Form des Grundkörpers nicht darauf beschränkt.

Insbesondere falls der Grundkörper eine kreisrunde Form aufweist, kann ein Durchmesser zwischen einem und zwei Millimetern betragen.

Die Aufgabe wird auch gelöst durch eine Konversionseinrichtung, aufweisend mindestens einen Konversionskörper wie oben beschrieben und eine mit der mindestens einen Leitungsspur elektrisch verbundene Auswerteeinrichtung, wobei die Auswerteeinrichtung dazu eingerichtet ist, einen Riss in dem Grundkörper anhand einer Änderung einer elektrischen Eigenschaft mindestens einer Leitungsspur festzustellen.

Dadurch kann ein Riss erheblich genauer und preiswerter festgestellt werden als mit optischen Methoden.

Die Konversionseinrichtung kann analog zu dem Konversionskörper ausgebildet werden und ergibt die gleichen Vorteile.

Die Auswerteeinrichtung kann beispielsweise dazu eingerichtet sein, einen elektrischen Widerstand der mindestens einen Leitungsspur, eine Spannung oder einen durch die Leitungsspur fließenden Strom zu bestimmen. So kann die Leitungsspur beispielsweise durch eine einfache Spannungsmessung z.B. über einen in Reihe zu einer Leitungsspur geschalteten Vorwiderstand R1 überwacht werden. Alternativ können der Vorwiderstand R1 und mindestens eine Leitungsspur als Stellwiderstand in einem Spannungsteiler dienen und die geteilte Spannung so überwacht werden.

Ist die Leitungsspur nicht beschädigt (Fall ohne Rissbildung) können der elektrische Widerstand gering und ein hindurchgeleiteter elektrischer Strom hoch sein. Für den Fall einer Beschädigung der Leitungsspur durch Rissbildung ändern sich die elektrischen Eigenschaften messbar, z.B. indem der elektrische Widerstand steigt und der elektrische Strom sinkt. Die Auswerteeinrichtung kann aber auch andere elektrische Eigenschaften messen, z.B. eine Spannung oder eine Kapazität. Die Messeinrichtung und die daran angeschlossene Auswertungseinrichtung sind insbesondere dazu geeignet, sich sprunghaft verändernde Messsignale (z.B. Spannungsmesswerte) sowie Messsignale mit sich stark verändernden Kurvenformen, beispielsweise einer plötzlichen Erhöhung der Kurvensteigung (entsprechend beispielsweise einer Ableitung erster Ordnung des Messsignals), zu detektieren. Weiterhin können die Messeinrichtung und/oder die Auswerteeinrichtung einen Datenspeicher aufweisen, der insbesondere Messwerte, welche in einem Nicht-Betriebszustand oder in einer Dunkelphase der Konversionseinrichtung gemessen wurden, speichert und abrufbar bereithält. Dadurch können zeitlich sequentiell vorliegenden Messsignale im Nicht-Betriebszustand miteinander verglichen werden, was zu einer Kalibrierung der Messeinrichtung bzw. der daran angeschlossene Auswertungseinrichtung verwendet werden kann. So können zum Beispiel aufgrund einer Temperaturerhöhung der Umgebung erhöhte Wiederstandwerte bei der Auswertung berücksichtigt und ggf. bei einer Auswertung kompensiert werden.

Es ist eine Weiterbildung, dass die Auswerteeinrichtung dazu eingerichtet ist, einen Riss in dem Grundkörper mittels einer dadurch bewirkten Verringerung einer Querschnittsfläche der Leitungsspur zu erkennen. So können Risse in dem Grundkörper besonders frühzeitig erkannt werden, insbesondere auch bei einem langsamen (speziell unterkritischen) Risswachstum.

Es ist eine Ausgestaltung, dass die Auswerteeinrichtung dazu eingerichtet ist, einen Riss in dem Grundkörper anhand einer Durchtrennung mindestens einer Leitungsspur festzustellen. Dies lässt sich besonders eindeutig und schnell feststellen, z.B. durch einen Sprung eines Widerstandswerts auf praktisch unendlich oder durch einen Stromabfall auf praktisch null.

Es ist noch eine Ausgestaltung, dass die Auswerteeinrichtung dazu eingerichtet ist, auf eine Feststellung einer Beschädigung, insbesondere Durchtrennung, der randseitigen Leitungsspur hin mindestens eine erste Aktion auszulösen und auf eine Feststellung einer Beschädigung, insbesondere Durchtrennung, mindestens einer weiteren Leitungsspur hin mindestens eine zweite Aktion, insbesondere eine Deaktivierung oder Abschaltung einer Bestrahlung des Grundkörpers, auszulösen. So kann eine abgestufte Reaktion auf eine Rissausbreitung erreicht werden, was insbesondere für den Fall vorteilhaft ist, dass der Riss eher langsam von der randseitigen Leitungsspur zu der sich näher an der Beleuchtungsfläche befindlichen weiteren Leitungsspur fortschreitet. Durch das Abschalten der Bestrahlung des Grundkörpers wird verhindert, dass die Bestrahlungsfläche bestrahlt wird, wenn ein Riss durch sie hindurchgeht. Dies wiederum verhindert eine Abstrahlung kohärenten Primärlichts und damit eine Augengefährdung bei beschädigtem oder sogar zerstörtem Grundkörper. Das Abschalten der Bestrahlung des Grundkörpers kann durch Ausschalten der Halbleiterlichtquelle(n) oder durch Einbringen einer Blende in einen Lichtpfad des Primärlichts umgesetzt werden.

Es ist eine Weiterbildung, dass die mindestens eine erste Aktion ein Reduzieren einer Strahlungsleistung des Primärlichts umfasst. So kann ein Rissfortschritt verlangsamt werden und mit der weiterhin durchgeführten Bestrahlung eine "Notlichtfunktion" aufrechterhalten werden.

Es ist noch eine Weiterbildung, dass die mindestens eine erste Aktion ein Ausgeben eines Warnsignals umfasst, z.B. an eine übergeordnete Instanz, beispielsweise zur Ausgabe eines Hinweissignals an einen Nutzer, ein Kontrollzentrum usw.

Es ist ferner eine Ausgestaltung, dass die Konversionseinrichtung einen Teil einer Beleuchtungsvorrichtung darstellt, insbesondere einer Fahrzeug-Beleuchtungsvorrichtung oder einer Effekt-, Bühnen- oder Außenbeleuchtung. Die Fahrzeug-Beleuchtungsvorrichtung kann insbesondere zur Außenbeleuchtung des Fahrzeugs vorgesehen sein, beispielsweise in Form eines Scheinwerfers. Der Scheinwerfer kann z.B. eine Abblendlicht-, eine Fernlicht-, eine Nebellicht-, eine Kurvenlicht- und/oder eine Tagfahrlicht-Funktion usw. aufweisen.

Die Aufgabe wird ferner gelöst durch eine Beleuchtungsvorrichtung, aufweisend mindestens einen Konversionskörper wie oben beschrieben und/oder mindestens eine Konversionseinrichtung wie oben beschrieben, und aufweisend mindestens eine Halbleiter-Primärlichtquelle zum Bestrahlen der Bestrahlungsfläche des zugehörigen Grundkörpers.

Die mindestens eine Halbleiterprimär-Lichtquelle kann mindestens eine Laserdiode und/oder mindestens eine Leuchtdiode aufweisen oder sein.

Es ist eine Ausgestaltung, dass die Auswerteeinrichtung mit der mindestens einen Halbleiter-Primärlichtquelle gekoppelt ist, ggf. über eine Steuereinrichtung wie eine Bordelektronik eines Fahrzeugs oder über ein Steuerpult eines Effektbeleuchtungssystems.

Die Beleuchtungsvorrichtung kann den Konversionskörper oder den Grundkörper in transmittiver Anordnung betreiben, bei der Nutzlicht von dem Grundkörper an der der Bestrahlungsfläche abgewandten Seite abgestrahlt wird. Das Nutzlicht kann bei Vollkonversion dem Sekundärlicht und bei Teilkonversion einer Mischung aus nicht-umgewandelten Primärlicht und dem Sekundärlicht entsprechen.

Zusätzlich oder alternativ kann die Beleuchtungsvorrichtung den Konversionskörper oder den Grundkörper in reflektiver Anordnung betreiben, bei der Nutzlicht von dem Grundkörper an der Seite abgestrahlt wird, die auch die Bestrahlungsfläche aufweist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden schematischen Beschreibung eines Ausführungsbeispiels, die im Zusammenhang mit den Zeichnungen näher erläutert werden. Dabei können zur Übersichtlichkeit gleiche oder gleichwirkende Elemente mit gleichen Bezugszeichen versehen sein.
- Fig.1: zeigt in Draufsicht eine Beleuchtungsvorrichtung mit einem Konversionskörper gemäß einem ersten Ausführungsbeispiel;
- Fig.2: zeigt in Draufsicht einen Konversionskörper gemäß einem zweiten Ausführungsbeispiel; und
- Fig.3: zeigt in Draufsicht einen Konversionskörper gemäß einem dritten Ausführungsbeispiel.

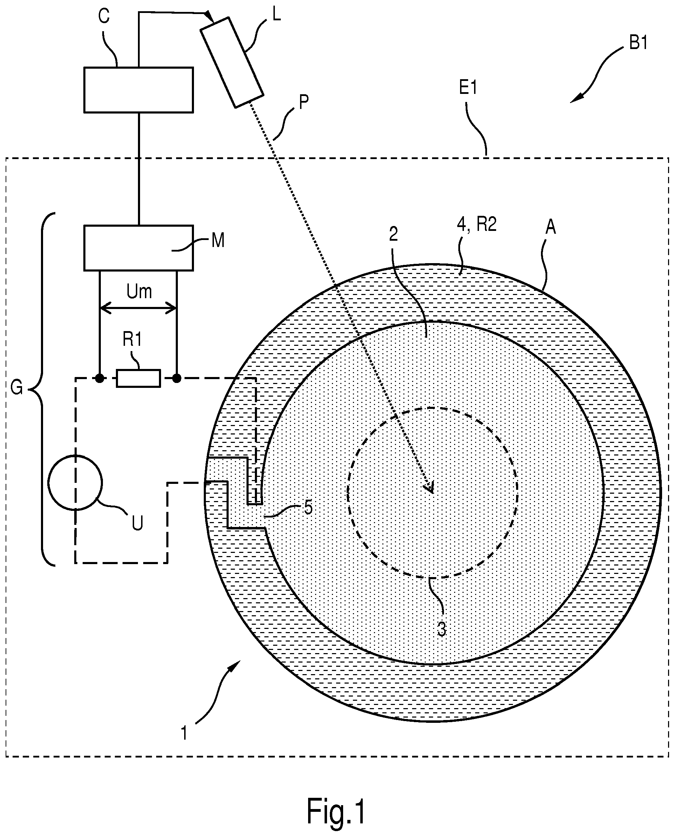

**Fig.1** zeigt in Draufsicht eine Beleuchtungsvorrichtung B1 mit einer Konversionseinrichtung E1, die einen Konversionskörper 1 gemäß einem ersten Ausführungsbeispiel aufweist.

Der Konversionskörper 1 weist einen kreisscheibenförmigen Grundkörper 2 aus wellenlängenumwandelnder Keramik auf, was auch als kreisförmiges Konversionskeramikplättchen bezeichnet werden kann. Mittig auf der gezeigten Vorderseite des Grundkörpers 2 ist eine gedachte Bestrahlungsfläche 3 vorgesehen, die mit - z.B. blauem - Primärlicht P zu bestrahlen ist. Außerhalb der Bestrahlungsfläche 3 sollte kein oder nur wenig Primärlicht P auftreffen.

Zumindest auf der gezeigten Vorderseite des Grundkörpers 2 ist eine elektrisch leitfähige Leitungsspur in Form einer z.B. aufgesputterten Leiterbahn 4 aus Aluminium aufgebracht. Die Leiterbahn 4 ist praktisch vollständig kreisringförmig ausgebildet und weist eine Außenkontur auf, welche bis an einen Rand A des Grundkörpers 2 reicht. Die Leiterbahn 4 verläuft somit praktisch vollständig entlang des Rands A. Nur an einer spaltartigen Unterbrechung 5 ist die Leiterbahn 4 aufgetrennt oder unterbrochen, um bei einem elektrischen Stromfluss einen Kurzschluss zu verhindern.

Die Leiterbahn 4 weist eine Breite von ca. 200 Mikrometern und eine Dicke von ca. 200 Nanometern auf. Ein Durchmesser des Grundkörpers 2 beträgt ca. ein bis zwei Millimeter.

An die offenen Enden der Leiterbahn 4 ist eine Auswerteeinrichtung G der Konversionseinrichtung E1 angeschlossen, die eine Gleichspannungsquelle U und einen Vorwiderstand R1 aufweist. Der Vorwiederstand R1 ist in Reihe mit der Leiterbahn 4 an die Gleichspannungsquelle U angeschlossen. Die an dem Vorwiederstand R1 anliegende Spannung kann über eine zu der Auswerteeinrichtung G gehörige Messeinrichtung M abgefühlt werden. Die von der Messeinrichtung M ermittelten Spannungsmesswerte können von einer mit der Messeinrichtung M verbundenen Steuereinrichtung C dazu verwendet werden, eine Primärlichtquelle in Form mindestens eines Lasers L anzusteuern. Die Steuereinrichtung C kann einen Teil der Auswerteeinrichtung G darstellen oder eine eigenständige Komponente sein. Die Steuereinrichtung C und die Auswerteeinrichtung G können auch in einer Komponente integriert sein, z.B. in eine Steuereinrichtung C mit Auswertungsfunktion. Die Konversionseinrichtung E1, umfassend die Auswerteeinrichtung G und den Konversionskörper 1, kann als ein Modul vorliegen.

Die Beleuchtungsvorrichtung B1 ist in einer Ausgestaltung folgendermaßen betreibbar:
Die Steuereinrichtung C steuert den mindestens einen Laser L so an, dass dieser die Beleuchtungsfläche 3 mit Primärlicht P einer Norm-Strahlungsleitung bestrahlt. Ist der Grundkörper 2 rissfrei, ist auch die Leiterbahn 4 rissfrei und weist für praktische Zwecke einen elektrischen Widerstand R2 ≈ 0 auf. Die Messeinrichtung M misst dann an dem Vorwiderstand R1 als Messspannung Um die von der Gleichspannungsquelle erzeugte Spannung U, d.h., dass für praktische Zwecke U = Um gilt.

Wird an dem Rand A ein Riss (o. Abb.) initiiert, läuft dieser in das Innere des Grundkörpers 2 und erzeugt einen analogen Riss oder eine entsprechende Auftrennung der Leiterbahn 4. Für den Fall, dass der Riss sich nur teilweise in einen Bereich unterhalb der Leiterbahn 4 bewegt hat, wird die Leiterbahn 4 dort angerissen, aber noch nicht unterbrochen. Der Widerstand R2 erhöht sich durch die daraus folgende Querschnittsverengung auf einen messbaren endlichen Wert. Die Messeinrichtung M misst dann an dem Vorwiderstand R1 als Messspannung Um einen Wert Um = R1/(R1+R2) · U. Die Steuereinrichtung C kann in einer Variante bereits daraufhin eine Strahlungsleistung des mindestens einen Lasers L verringern, um eine weitere Rissausbreitung zu verlangsamen oder sogar zunächst zu verhindern.

Wenn der Riss den Grundkörper 2 ganz unterhalb der Leiterbahn 4 gequert hat und dadurch auch die Leiterbahn 4 dort durch- bzw. aufgetrennt hat, misst die Messeinrichtung M einen Wert Um = 0, was sehr gut feststellbar ist. Die Steuereinrichtung C kann dann eine Strahlungsleistung des mindestens einen Lasers L (noch stärker) verringern, um eine weitere Rissausbreitung zu verlangsamen oder sogar zunächst zu verhindern. Sie kann insbesondere die Strahlungsleistung des Primärlichts P auf Null reduzieren (insbesondere den Laser L ausschalten oder deaktivieren), um eine weitere Rissausbreitung sicher zu verhindern.

Diese Schutzfunktion dient insbesondere dazu, einen aufgrund eines beschädigten Grundkörpers 2 erfolgten Austritt von konzentriertem Primärlicht P aus der Beleuchtungsvorrichtung B1 zu verhindern.

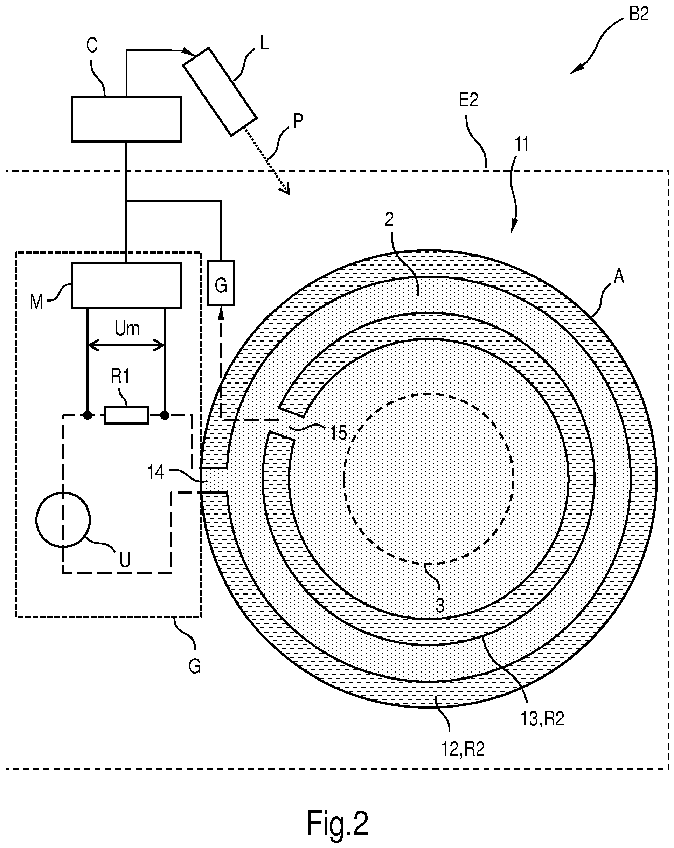

**Fig.2** zeigt in Draufsicht eine Beleuchtungsvorrichtung B2 mit einem Konversionskörper 11 gemäß einem zweiten Ausführungsbeispiel. Der Konversionskörper 11 weist nun zwei konzentrisch auf dem Grundkörper 2 aufgebrachte ringförmige Leiterbahnen 12 und 13 auf, von denen eine Leiterbahn 12 eine randseitige Leiterbahn ähnlich der Leiterbahn 4 ist. Die Leiterbahn 12 kann so dünn sein, dass bei einer randseitig initiierten Rissbildung in dem Grundkörpers 2 vor allem ihre Durchtrennung sinnvoll messbar und auswertbar ist. Die weitere Leiterbahn 13 verläuft zwischen der randseitigen Leiterbahn 12 und der Bestrahlungsfläche 3. Die weitere Leiterbahn 13 ist wie die Leiterbahn 12 ringförmig ausgebildet und damit formähnlich zu dieser. Die schmalen Unterbrechungen 14 und 15 der Leiterbahnen 12 bzw. 13 sind zueinander winkelversetzt, um zu verhindern, dass sich ein Riss durch beide Unterbrechungen 14 und 15 hindurch ausbreiten kann. Elektrische Verbindungsleitungen (o. Abb.) zwischen der Messeinrichtung M und der Leiterbahn 13 können vorteilhafterweise durch die Unterbrechung 14 der randseitigen Leiterbahn 12 durchgeführt sein, beispielsweise in Form von dünnen, schmalen, leiterbahnartigen Aluminium-Beschichtungen oder optisch transparenten ITO-Leiterbahnen.

Es ist eine Weiterbildung, dass elektrische Eigenschaften der Leiterbahnen 12 und 13 ähnlich zu der Leiterbahn 4 abgefühlt werden können, z.B. eine jeweilige Messspannung Um gemessen werden kann, insbesondere individuell für jede einzelne der beiden Leiterbahnen 12 und 13. Dazu können zwei Auswerteeinrichtungen G vorhanden sein, die aber auch zumindest teilweise ineinander integriert sein können, z.B. indem sie eine gemeinsame Gleichspannungsquelle U nutzen. Eine Konversionseinrichtung E2 kann dann den Konversionskörper 11 und beide Auswerteeinrichtungen G aufweisen.

Die Steuereinrichtung C kann dann jede der Messspannung Um für eine Ansteuerung des mindestens einen Lasers L nutzen.

Die Beleuchtungsvorrichtung B2 ist dann - insbesondere analog zu der Beleuchtungsvorrichtung B1 aus Fig.1 - in einer Ausgestaltung folgendermaßen betreibbar:
Eine Steuereinrichtung C steuert den mindestens einen Laser L so an, dass dieser die Beleuchtungsfläche 3 des Grundkörpers 2 mit Primärlicht P einer Norm-Strahlungsleitung bestrahlt.

Ist der Grundkörper 2 rissfrei, sind auch die Leiterbahnen 12 und 13 rissfrei und weisen für praktische Zwecke einen elektrischen Widerstand R2 ≈ 0 auf. Die (jeweilige oder gemeinsame) Messeinrichtung M misst dann an einem jeweiligen Vorwiderstand R1 als Messspannung Um die von der (jeweiligen oder gemeinsamen) Gleichspannungsquelle U erzeugte Spannung.

Wird an dem Rand A des Grundkörpers 2 ein Riss (o. Abb.) initiiert, läuft dieser in das Innere des Grundkörpers 2 und trennt zunächst die randseitige Leiterbahn 12 auf, so dass diese unterbrochen wird. Die Steuereinrichtung C kann daraufhin eine Strahlungsleistung des mindestens einen Lasers L verringern, um eine weitere Rissausbreitung zu verlangsamen oder sogar zunächst zu verhindern.

Mit Durchtrennung der randseitigen Leiterbahn 12 kann die Steuereinrichtung C auch andere Aktionen auslösen, beispielsweise einen Hinweis auf einen Nutzer der Beleuchtungsvorrichtung B2 ausgeben und/oder eine Serviceinstanz (z.B. eine Werkstatt) informieren.

Wenn der Riss den Grundkörper 2 unterhalb der Leiterbahn 13 gequert hat und dadurch auch die Leiterbahn 13 dort durch- bzw. aufgetrennt hat, kann die Steuereinrichtung C dann z.B. die Strahlungsleistung des Primärlichts P auf Null reduzieren (insbesondere den Laser L ausschalten oder deaktivieren), um eine weitere Rissausbreitung sicher und/oder eine Bestrahlung einer rissbehafteten Bestrahlungsfläche 3 zu verhindern.

Auch diese Schutzfunktion dient dazu, einen aufgrund eines beschädigten Grundkörpers 2 erfolgten Austritt von konzentriertem Primärlicht P aus der Beleuchtungsvorrichtung B2 zu verhindern.

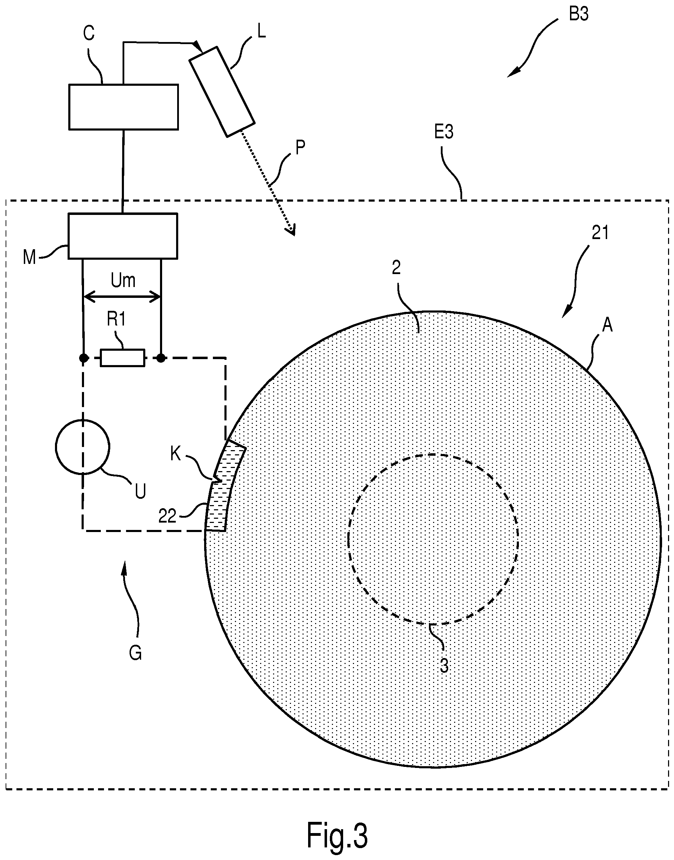

**Fig.3** zeigt in Draufsicht eine Beleuchtungseinrichtung B3, die eine Konversionseinrichtung E3 mit einem Konversionskörper 21 gemäß einem dritten Ausführungsbeispiel aufweist.

Die Beleuchtungseinrichtung B3 kann beispielsweise ähnlich zu der Beleuchtungseinrichtung B1 betrieben werden. Jedoch ist nun die Leiterbahn 22 nicht randseitig umlaufend ausgebildet, sondern verläuft nur entlang eines kurzen Abschnitts oder Sektors (z.B. von nicht mehr als 45°, insbesondere von nicht mehr als 20°, insbesondere von nicht mehr als 10°, des Gesamtumfangs bzw. Rands A). Um dennoch eine mechanische Überlastung des Grundkörpers 2 durch eine thermisch induzierte randseitige Zugspannung aufgrund einer Bestrahlung der Bestrahlungsfläche 3 mit dem Primärlicht P sicher feststellen zu können, ist an dem Abschnitt des Rands A, an dem sich die Leiterbahn 22 befindet, eine gezielt eingebrachte, vordefinierte Vorschädigung in Form einer (Mikro-)Kerbe K vorhanden. Erreicht die Zugspannung am Rand A einen zumindest ungefähr einstellbaren Schwellwert, so wird an der Kerbe K ein nach innen laufender Riss erzeugt, der mittels einer Durchbrechung usw. der Leiterbahn 22 erkennbar ist.

Es können auch mehrere Leiterbahnen 22 mit jeweiligen Kerben K vorgesehen sein, z.B. gleichmäßig um den Rand A bzw. den Umfang verteilt.

Obwohl die Erfindung im Detail durch die gezeigten Ausführungsbeispiele näher illustriert und beschrieben wurde, so ist die Erfindung nicht darauf eingeschränkt und andere Variationen können vom Fachmann hieraus abgeleitet werden, ohne den Schutzumfang der Erfindung zu verlassen.

So kann anstelle einer Leiterbahn aus Aluminium auch eine Leiterbahn aus einem anderen Metall wie Kupfer oder Zinn verwendet werden. Auch kann anstelle einer Leiterbahn ein in den Grundkörper eingebetteter Draht, insbesondere aus oder mit Wolfram, vorgesehen sein.

Auch können der Grundkörper und die Leiterbahn(en) oval, eckig (beispielsweise rechteckig, insbesondere quadratisch) und allgemein freiförmig geformt sein.

Zudem können auch noch mehr als eine weitere Leiterbahn vorgesehen sein.

Allgemein kann unter "ein", "eine" usw. eine Einzahl oder eine Mehrzahl verstanden werden, insbesondere im Sinne von "mindestens ein" oder "ein oder mehrere" usw., solange dies nicht explizit ausgeschlossen ist, z.B. durch den Ausdruck "genau ein" usw.

Auch kann eine Zahlenangabe genau die angegebene Zahl als auch einen üblichen Toleranzbereich umfassen, solange dies nicht explizit ausgeschlossen ist.

### Bezugszeichen

- 1: Konversionskörper
- 2: Grundkörper
- 3: Bestrahlungsfläche
- 4: Leiterbahn
- 5: Unterbrechung
- 11: Konversionskörper
- 12: Randseitige Leiterbahn
- 13: Weitere Leiterbahn
- 14: Unterbrechung der randseitigen Leiterbahn
- 15: Unterbrechung der weiteren Leiterbahn
- 21: Konversionskörper
- 22: Leiterbahn
- A: Rand des Grundkörpers
- B1: Beleuchtungsvorrichtung
- B2: Beleuchtungsvorrichtung
- B3: Beleuchtungsvorrichtung
- C: Steuereinrichtung
- E1: Konversionseinrichtung
- E2: Konversionseinrichtung
- E3: Konversionseinrichtung
- G: Auswerteeinrichtung
- K: Kerbe
- L: Laser
- M: Messeinrichtung
- P: Primärlicht
- R1: Vorwiderstand
- R2: Widerstand der Leiterbahn
- U: Gleichspannungsquelle
- Um: Messspannung

## Patentansprüche

1. Konversionskörper (1; 11; 21), aufweisend
- einen Grundkörper (2) aus wellenlängenumwandelndem Leuchtstoff, der eine zur Bestrahlung mit Primärlicht (P) vorgesehene Bestrahlungsfläche (3) aufweist,
wobei der Grundkörper (2) ein Leuchtstoffplättchen ist, dessen Bestrahlungsfläche (3) sich mittig auf einer Flachseite des Grundkörpers (2) befindet, und
- mindestens eine auf dem Grundkörper (2) außerhalb der Bestrahlungsfläche (3) angebrachte elektrisch leitfähige Leitungsspur (4; 12, 13; 22), wobei
- zumindest eine randseitige Leitungsspur (4; 12; 22) entlang zumindest eines Teils eines Rands (A) der die Bestrahlungsfläche (3) aufweisenden Flachseite verläuft,
**dadurch gekennzeichnet, dass**
die randseitige Leitungsspur (12) entlang mindestens einer randseitig eingebrachten mechanischen Vorschädigung (K) verläuft und mindestens eine weitere Leitungsspur (13), beabstandet und formähnlich zur randseitigen Leitungsspur (12), zwischen der randseitigen Leitungsspur (12) und der Bestrahlungsfläche (3) verläuft.

2. Konversionskörper (1; 11) nach Anspruch 1, wobei die randseitige Leitungsspur (4; 12) praktisch entlang des ganzen Rands (A) der die Bestrahlungsfläche (3) aufweisenden Flachseite verläuft.

3. Konversionskörper (1; 11; 21) nach einem der vorhergehenden Ansprüche, bei dem der Grundkörper (2) aus wellenlängenumwandelnder Keramik besteht.

4. Konversionskörper (1; 11; 21) nach einem der vorhergehenden Ansprüche, bei dem die elektrisch leitfähige Leitungsspur (4; 12, 13; 22) eine Leiterbahn, insbesondere aus Aluminium, ist.

5. Konversionskörper nach einem der vorhergehenden Ansprüche, bei dem die elektrisch leitfähige Leitungsspur ein in den Grundkörper (2) eingebetteter Draht, insbesondere aufweisend Wolfram, ist.

6. Konversionseinrichtung (E1; E2; E3), aufweisend mindestens einen Konversionskörper (1; 11; 21) nach einem der vorhergehenden Ansprüche und eine mit der mindestens einen Leitungsspur (4; 12, 13; 22) verbundene Auswerteeinrichtung (G), wobei die Auswerteeinrichtung (G) dazu eingerichtet ist, einen Riss in dem Grundkörper (2) anhand einer Änderung einer elektrischen Eigenschaft mindestens einer Leitungsspur (4; 12, 13; 22) festzustellen.

7. Konversionseinrichtung (E1; E2; E3) nach Anspruch 6, bei der die Auswerteeinrichtung (G) dazu eingerichtet ist, einen Riss in dem Grundkörper (2) anhand einer Durchtrennung mindestens einer Leitungsspur (4; 12, 13; 22) festzustellen.

8. Konversionseinrichtung (E2) nach Anspruch 7 mit einem Konversionskörper (11) nach Anspruch 1, bei der die Auswerteeinrichtung (G) dazu eingerichtet ist,
- auf eine Feststellung einer Durchtrennung der randseitigen Leitungsspur (12) hin mindestens eine erste Aktion auszulösen und
- auf eine Feststellung einer Durchtrennung mindestens einer weiteren Leitungsspur (13) hin eine Abschaltung einer Bestrahlung des Grundkörpers (2) auszulösen.

9. Konversionseinrichtung (E1; E2; E3) nach einem der Ansprüche 6 bis 8, wobei die Konversionseinrichtung (E1; E2; E3) einen Teil einer Beleuchtungsvorrichtung (B1; B2; B3) darstellt.

10. Beleuchtungsvorrichtung (B1; B2; B3), aufweisend mindestens eine
- Konversionseinrichtung (E1; E2; E3) nach einem der Ansprüche 6 bis 9 und
- mindestens eine Halbleiter-Primärlichtquelle (L) zum Bestrahlen der Bestrahlungsfläche (3) des zugehörigen Grundkörpers (2), wobei
- die Auswerteeinrichtung (G) mit der mindestens einen Halbleiter-Primärlichtquelle (L) gekoppelt ist.

## Claims

1. Conversion body (1; 11; 21), comprising
- a main body (2) made from wavelength converting phosphor, said main body having an irradiation surface (3), intended to be irradiated by primary light (P),
wherein the basic body (2) is a phosphor platelet, the irradiation surface (3) of which is centered on a flat side of the main body (2), and
- at least one electrically conductive conduction track (4; 12, 13; 22) mounted on the main body (2) outside the irradiation surface (3), wherein
- at least one edge-side conduction track (4; 12; 22) extends along at least a portion of one edge (A) of the flat side that comprises the irradiation surface (3),
**characterized in that**
the edge-side conduction track (12) extends along at least one mechanical damage site (K) introduced on the edge side and at least one other conduction track (13) extends, a distance apart from and similar in shape to the edge-side conduction track (12), between the edge-side conduction track (12) and the irradiation surface (3).

2. Conversion body (1; 11) according to Claim 1, wherein the edge-side conduction track (4; 12) extends along almost the whole edge (A) of the flat side comprising the irradiation surface (3).

3. Conversion body (1; 11; 21) according to any one of the previous claims, in which the main body (2) consists of wavelength-converting ceramic.

4. Conversion Body (1; 11; 21) according to any one of the previous claims, in which the electrically conductive conduction track (4; 12, 13; 22) is a conductor track, in particular, made of aluminum.

5. Conversion body according to any one of the previous claims, in which the electrically conductive conduction track is a wire embedded in the main body (2) and in particular comprising tungsten.

6. Conversion device (E1; E2; E3), comprising at least one conversion body (1; 11; 21) according to any one of the preceding claims, and an evaluation device (G) connected to the at least one conduction track (4; 12, 13; 22), the evaluation device (G) being configured to detect a crack in the main body (2) on the basis of a change in an electric property of at least one conduction track (4; 12, 13; 22).

7. Conversion device (E1; E2; E3) according to Claim 6, in which the evaluation device (G) is configured to detect a crack in the main body (2) on the basis of a breakage of at least one conduction track (4; 12:13; 22).

8. Conversion device (E2) according to Claim 7, having a conversion body (11) according to Claim 1, in which the evaluation device (G) is configured
- to trigger at least one first action upon detecting a breakage in the edge-side conduction track (12) and
- to trigger a deactivation of an irradiation of the main body (2) upon detecting a breakage of at least one additional conduction track (13).

9. Conversion device (E1; E2: E3) according to any one of Claims 6 to 8, wherein the conversion device (E1; E2; E3) represents a part of an illumination apparatus (B1; B2; B3).

10. Illumination apparatus (B1; (B2, B3), having at least one
- conversion device (E1; E2: E3) according to any one of Claims 6 to 9, and
- at least one semiconductor primary light source (L) for irradiating the irradiation surface (3) of the associated main body (2), wherein
- the evaluation device (G) is linked to the at least one semiconductor primary light source (L).

## Revendications

1. Corps de conversion (1, 11, 21), comprenant
- un corps de base (2) constitué d'une substance luminescente de conversion de longueur d'onde, qui possède une surface d'irradiation (3) destinée à irradier de la lumière primaire (P), dans lequel le corps de base (2) est une plaquette de substance luminescente dont la surface d'irradiation (3) se trouve au milieu sur une face plate du corps de base (2), et
- au moins une voie de conduction (4, 12, 13, 22) électriquement conductrice placée sur le corps de base (2) à l'extérieur de la surface d'irradiation (3), dans lequel
- au moins une voie de conduction de bordure latérale (4, 12, 22) est formée le long d'au moins une partie d'un bord (A) du côté plat comprenant la surface d'irradiation (3),
**caractérisé en ce que**
la voie de conduction de bordure latérale (12) passe le long d'au moins une pré-détérioration mécanique (K) introduite en bordure latérale et au moins une autre voie de conduction (13) de forme similaire à la voie de conduction de bordure latérale (12) est formée à distance de celle-ci, entre la voie de conduction de bordure latérale (12) et la surface d'irradiation (3).

2. Corps de conversion (1, 11) selon la revendication 1, dans lequel la voie de conduction de bordure latérale (4, 12) longe pratiquement le bord entier (A) du côté plat comprenant la surface d'irradiation (3).

3. Corps de conversion (1, 11, 21) selon l'une des revendications précédentes, dans lequel le corps de base (2) est constitué d'une céramique de conversion de longueur d'onde.

4. Corps de conversion (1, 11, 21) selon l'une des revendications précédentes, dans lequel la voie de conduction électriquement conductrice (4, 12, 13, 22) est une piste conductrice, notamment en aluminium.

5. Corps de conversion selon l'une des revendications précédentes, dans lequel la voie de conduction électriquement conductrice est un fil incorporé dans le corps de base (2), qui comprend notamment du tungstène.

6. Dispositif de conversion (E1, E2, E3), comprenant au moins un corps de conversion (1, 11, 21) selon l'une des revendications précédentes et un moyen d'évaluation (G) relié à au moins une voie de conduction (4, 12, 13, 22), dans lequel le moyen d'évaluation (G) est configuré pour détecter une fissure (2) dans le corps de base (2) à partir d'une variation d'une propriété électrique d'au moins une voie de conduction (4, 12, 13, 22).

7. Dispositif de conversion (E1, E2, E3) selon la revendication 6, dans lequel le moyen d'évaluation (G) est configuré de manière à détecter une fissure dans le corps de base (2) à partir d'un sectionnement d'au moins une voie de conduction (4, 12, 13, 22).

8. Dispositif de conversion (E2) selon la revendication 7 comprenant un corps de conversion (11) selon la revendication 1, dans lequel le moyen d'évaluation (G) est configuré pour :
- à la suite d'une détection d'un sectionnement de la voie de conduction de bordure latérale (12), déclencher au moins une première action, et
- à la suite d'une détection d'un sectionnement d'au moins une autre voie de conduction (13), déclencher une désactivation d'une irradiation du corps de base (2).

9. Dispositif de conversion (E1, E2, E3) selon l'une des revendications 6 à 8, dans lequel le dispositif de conversion (E1, E2, E3) constitue une partie d'un dispositif d'éclairage (B1, B2, B3).

10. Dispositif d'éclairage (B1, B2, B3), comprenant
- au moins un dispositif de conversion (E1, E2, E3) selon l'une des revendications 6 à 9, et
- au moins une source de lumière primaire à semi-conducteur (L) destinée à irradier la surface d'irradiation (3) du corps de base (2) associé,
dans lequel
- le moyen d'évaluation (G) est couplé à la au moins une source de lumière primaire (L) à semi-conducteur.
